Europäisches Patentamt

(19) European Patent Office   (11) Publication number: **0 048 610**

Office européen des brevets                    **B1**

---

(12)                    EUROPEAN PATENT SPECIFICATION

(45) Date of publication of patent specification: **15.01.86**   (51) Int. Cl.⁴: **H 01 L 23/52,** H 01 L 21/90, G 11 C 11/40

(21) Application number: **81304319.7**

(22) Date of filing: **21.09.81**

(54) **Semiconductor device and its manufacture.**

(30) Priority: **22.09.80 JP 132146/80**
**22.09.80 JP 132147/80**

(43) Date of publication of application:
**31.03.82 Bulletin 82/13**

(45) Publication of the grant of the patent:
**15.01.86 Bulletin 86/03**

(84) Designated Contracting States:
**DE FR GB**

(56) References cited:
**DE-A-2 733 514**
**US-A-3 576 478**
**US-A-4 209 716**
**US-A-4 278 989**

(73) Proprietor: **Kabushiki Kaisha Toshiba**
**72, Horikawa-cho Saiwai-ku**
**Kawasaki-shi Kanagawa-ken 210 (JP)**

(72) Inventor: **Ariizumi, Shoji**
**72 Horikawa-cho Saiwai-ku**
**Kawasaki-shi Kanagawa-ken (JP)**
Inventor: **Segawa, Makoto**
**72 Horikawa-cho Saiwai-ku**
**Kawasaki-shi Kanagawa-ken (JP)**

(74) Representative: **Kirk, Geoffrey Thomas et al**
**BATCHELLOR, KIRK & EYLES 2 Pear Tree Court**
**Farringdon Road**
**London EC1R 0DS (GB)**

Courier Press, Leamington Spa, England.

## Description

This invention relates to a semiconductor device formed by a succession of layers on a substrate.

In previously proposed semiconductor integrated circuit devices the required conductors have been formed by metal layers, diffusion regions formed in the semiconductor substrate, and polycrystalline silicon (poly-Si) layers. In particular, poly-Si layers have frequently been used in semiconductors have multiple conductive layers.

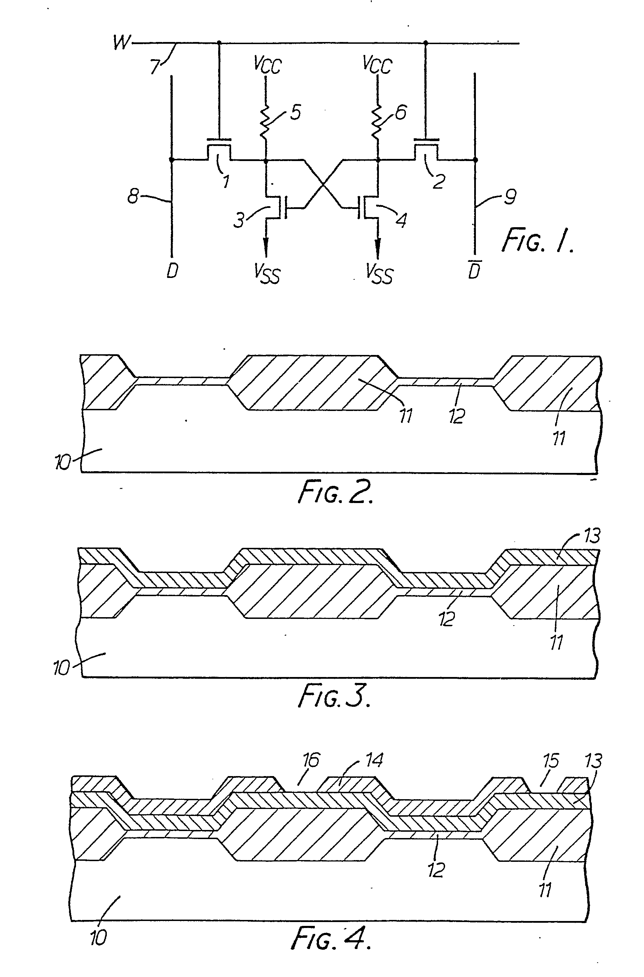

In particular, in a static RAM (Random Access Memory) with four transistors and two resistors per 1-bit cell, a first poly-Si layer has been used as the gate electrodes of the MOS transistors and for the wiring layers between circuit elements, and a second poly-Si layer has been used to form the resistors. The circuit of such a static RAM is shown in Figure 1, in which MOS transistors 1 and 2 operate as signal transferring gates and MOS transistors 3 and 4 form a flip-flop circuit. The sources of transistors 3 and 4 are connected to earth terminals Vss and resistors 5 and 6 are loads for both transistors and are connected to power source Vcc. The gates of transistors 1 and 2 are connected to word line 7 carrying the address-decode signals, and the sources of those transistors are connected respectively to data lines 8 and 9, the signals on each of which are inverse to those on the other. Data lines 8 and 9 have previously been made of aluminium and the word line of poly-Si.

The delay time of the address-decode signal on word line 7 is a problem and, in previous high-speed static RAM's, has often been over the tolerance limit. The delay time of the address-decode signal is predominantly determined by the product RC of the gate capacitance C of transfer gates 1 and 2 and the resistive value R of the word line 7. As it is determined by the characteristics required of the transistors, the gate capacitance C is difficult to decrease, and in practice the delay time can be reduced only by reducing the resistive value R of the word line.

In U.S. Patent no. 4,209,716, a static RAM device is described having substantially the features mentioned above. In particular in U.S. 4,209,716 a first conductive level of polysilicon is used to form gates of transistors of a memory device, and a second conductive level has regions of relatively low conductivity which form resistors.

In our European Patent application No. 80300661.8 published under No. 0016577 after the priority date of the present application, we have proposed to reduce the resistive value of the word line by employing for the latter two poly-Si conductive layers connected in parallel through contact holes. With that arrangement, resistors can be formed only by depositing a third conductive layer of the desired resistivity over the second layer of the word line, since the word line layers are of low resistance. The result is to increase unnecessarily the thickness of the semiconductor, to enlarge unduly the contact holes, and to exaggerated differences in level of the upper surfaces.

It is accordingly an object of the present invention to reduce the resistance of a conductor of a semiconductor device, to enable the device to operate at high speed, while avoiding the problems mentioned above.

In a first form, the invention provides a semiconductor device having a plurality of semiconductor elements having at least one PN junction, the device comprising a substrate; a first insulation layer on the substrate; a first conductive level on the first insulation layer; a second insulation layer on the first conductive layer; and a second conductive level on the second insulation layer, the second conductive layer having at least two separate regions of which a first region has relatively high conductivity, and a second region which has relatively low conductivity and forms resistor means, characterised in that the first region of relatively high conductivity of the second conductive level is connected in parallel with the first conductive layer through a plurality of contact holes. The first conductive layer and the first region of the second conductive layer may constitute a conductor, for example the word line of a high-speed RAM: by employing two conductor layers connected in parallel the resistance of the conductor is lowered with a decrease in the delay time.

In a second form of the invention, a memory device comprising a plurality of memory cells for storing information, each memory cell including a plurality of MOS transistors, and a resistor connected to an electrode of one of the MOS transistors, made of polycrystalline silicon and forming a first region of a second conductive level; a word line connected to the memory cells for selecting a desired memory cell, the word line being constituted by two separated conductive layers connected in parallel and forming respectively a first conductive level and a second region of the second conductive level separated from the first region and having a higher conductivity than the first region; and a data line connected to each memory cell through a gate operated by a signal from the word line, the resistor and the second region being formed on an insulating layer having substantially uniform thickness.

The invention includes a method of manufacturing a semiconductor device, which method includes the steps of: forming a first insulation layer on a semiconductor substrate; forming a first conductive level on the first insulating layer; forming a second insulating layer on the first conductive level; forming a second conductive layer over the second insulating layer, the second conductive level including a first region connected to the first conductive level in parallel and a second region constituting resistive means; and increasing the conductivity of the region connected to the first conductive level.

The invention will be more readily understood by way of example from the following description of semiconductors in accordance therewith, and their method of manufacture, reference being made to the accompanying drawings, in which:

Figure 1 is a circuit diagram of one data cell of a high-speed, integrated, semiconductor RAM;

Figures 2 to 6 are sectional views illustrating successive steps of manufacturing a semiconductor device;

Figure 7 is a plan view of the semiconductor device of Figures 2 to 6;

Figure 8 is a sectional view of the semiconductor device taken at right angles to the view of Figure 2 to 6, while Figure 9 is a plan view of a word line of that device;

Figures 10 to 13 are sectional views illustrating successive steps in the manufacture of a second form of semiconductor device;

Figure 14 is a plan view of the semiconductor device of Figures 10 to 13;

Figure 15 is a sectional view of the semiconductor device taken at right angles to the views of Figures 10 to 13; and

Figure 16 is a plan view of the word line of the semiconductor device of Figure 15.

Referring first to Figures 2 to 6, the successive steps of making the semiconductor device are as follows:—

1. A field silicon oxide ($SiO_2$) layer 11 is formed by selective surface oxidation of a P-type silicon substrate 10, as shown in Figure 2. The resistivity of substrate 10 is desirably between 20 and 50 ohms/cm and the insulation layer has a thickness of about 1 µm.

2. A gate oxide layer 12 is formed on substrate 10 by thermal oxidation. Gate oxide layer 12 has a thickness of about 40—100 nm (400 to 1000 Å). After this step, the gate oxide layer 12 is selectively etched.

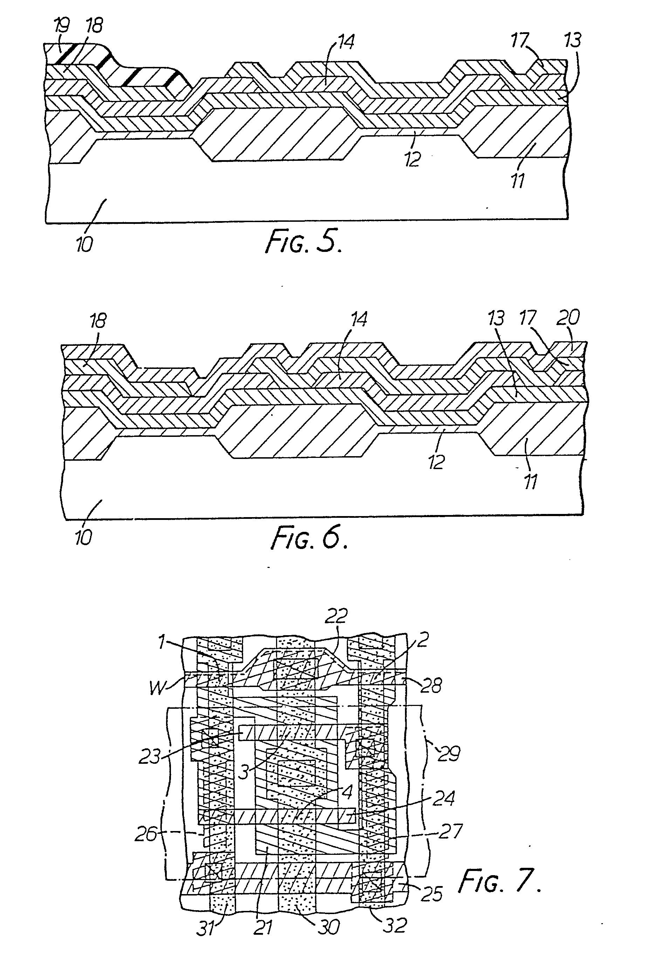

3. A poly-Si layer 13 is deposited on the insulation layers 11, 12 by chemical vapour deposition (Figure 3). Phosphorous ions as impurities are defused into the poly-Si layer 13 in order to reduce the resistivity of that layer. Poly-Si layer 13 is selectively etched to form the gate electrodes of the RAM and a wiring layer between circuit elements.

4. Arsenic ions as impurities are defused into the substrate 10 by using the field insulation layer 11 and the conductive layer 13 as a mask. $N^+$ regions are thereby formed in the substrate 10 and act as source and drain regions of the MOS transistors (not shown). The arsenic ions may be replaced by phosphorus ions in the diffusion process.

5. The poly-Si conductive layer 13 is covered by a second insulation layer 14 (Figure 4). Layer 14 has a uniform thickness of about 200—400 nm (2000 to 4000 Å) and is made of $SiO_2$ by a thermal oxidation technique or chemical vapour deposition.

6. Contact holes as shown at 15 and 16 are formed by etching the insulation layer 14 selectively (Figure 4).

7. A second poly-Si conductive layer is deposited over the second insulation layer 14 (Figure 5) and is selectively etched using a photo-resist mask with a required pattern to form separate regions 17 and 18, which form an additional wiring layer and a resistive element, respectively.

8. The poly-Si layer 18 forming the resistive elements is covered by a photo-resist layer 19 (Figure 5); the photo-resist layer may be replaced by a $SiO_2$ layer.

9. An impurity, for example phosphorous ions, is defused into layer 17 to increase its conductivity. That impurity is not defused into layer 18, because of the presence of the photo-resist layer 19, and therefore the layer 17 forming the additional layer has a relatively low resistivity while the layer 18 used as resistance elements has a relatively high resistivity. As is apparent from Figure 5 layer 17 is connected in parallel with the first conductive layer 13 through contact holes 15 and 16.

10. Photo-resist layer 19 is removed and an insulation layer 20 is applied to the poly-Si layers 17 and 18 (Figure 6). Insulation layer 20 has a thickness of about 1 µm and is made of $SiO_2$.

11. Contact holes are formed by photo-engraving and an external conductive aluminium is formed on the insulation layer 20 over and through the contact holes.

In memory semiconductors formed as described above, the first conductive layer 13 and the additional second wiring layer 17 are connected in parallel so that the resistivity of the wiring layer is half of the prior devices using a single conductive layer. Also layers 17 and 18, which are formed in the same step, are used as, respectively, the additional wiring layer and as resistance elements, so that the insulating layer there below is maintained at a uniform thickness and the differences in thicknesses of the entire semiconductor is reduced. Those improvements are obtained in a simple manner.

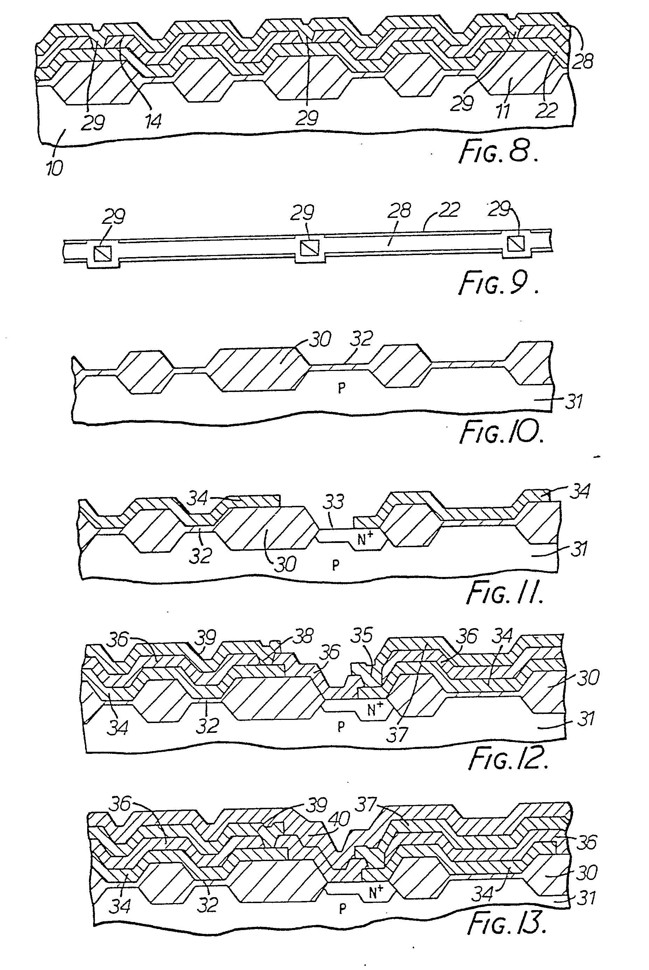

The pattern of a memory cell as in Figure 1 when formed as described above is shown in Figure 7. Region 21 there shown is the $N^+$ region operating as the sources and drain areas of the transistors 1, 2, 3 and 4. Regions 22, 23, 24 and 25 are the first poly-Si layer (13 in Figures 2 to 6) and constitute the gate electrodes of transistors 1 and 2 and the word line 7, the gate electrode or transistor 3, the gate electrode of transistor 4, and the conductive layer 2 to terminal Vcc. Layers 23 and 24 are respectively connected to the drain regions of transistors 3 and 4 through the contact holes. Regions 26 and 27 are the second poly-Si layer having high resistivity (regions 18 in Figure 5) and form the resistors 5 and 6 respectively. Each resistor so formed is connected at one end to the gate electrode of transistor 3 or 4, and the other end is connected to Vcc line 25. Region 28 shown surrounded by a dotted line, is the second poly-Si layer having low resistivity (17 in Figure 5) and forms the additional wiring layer connected in parallel to word line 22 through the contact holes 15, 16. The resistivity of this poly-Si layer is reduced, as above mentioned, by ion-implantation, for which $SiO_2$ mask layer 29 is applied to resistive layers 26 and 27. Regions 30, 31, 32 are aluminium layers and form respectively the earth line Vss and the data lines 8 and 9.

In the structure as described above, the first poly-Si layer 13 has lower resistivity and is used as the active elements — electrodes of the transistors and the data line. The second poly-Si layer (17, 18) includes the low resistivity region 17 and the high resistivity region 18. The latter region is used as the resistors, while the former region is employed as the additional wiring layer connected in parallel to the first poly-Si layer 13. Resistors 26, 27 (Figure 7) can be formed over the flip-flop circuit constructed by transistors 3 and 4 and the additional wiring layer 28 may be arranged over the transistors 1 and 4 in parallel with word line 22.

Figure 8 shows the connection of the first and second poly-Si layers 22 and 28 (13 and 17) through a number of contact holes 29, while Figure 9 shows that the second poly-Sl layer 28 is narrower than the first such layer 22, in order to alleviate the difference in level of the double poly-Si layers relative to the remainder of the semiconductor.

Because the resistivity of the word line 7 is substantially half the previous values, the delay time of the word line 7 is reduced and a high-speed memory device is achieved. Further, as the second poly-Si layer (17, 18) formed in a single step is utilized both as a conductor and as the resistors, the process is simplified. The contact holes should be made as large as is conveniently possible, to hold the resistivity of the word line to a low level.

By appropriate modification, the process described above may be employed to make an integrated circuit having at least one low-resistivity layer formed by high doped poly-Si as used for example as a wiring layer, at least one inverter made of low doped poly-Si, and a driving MOS, the gate of which receives an input signal.

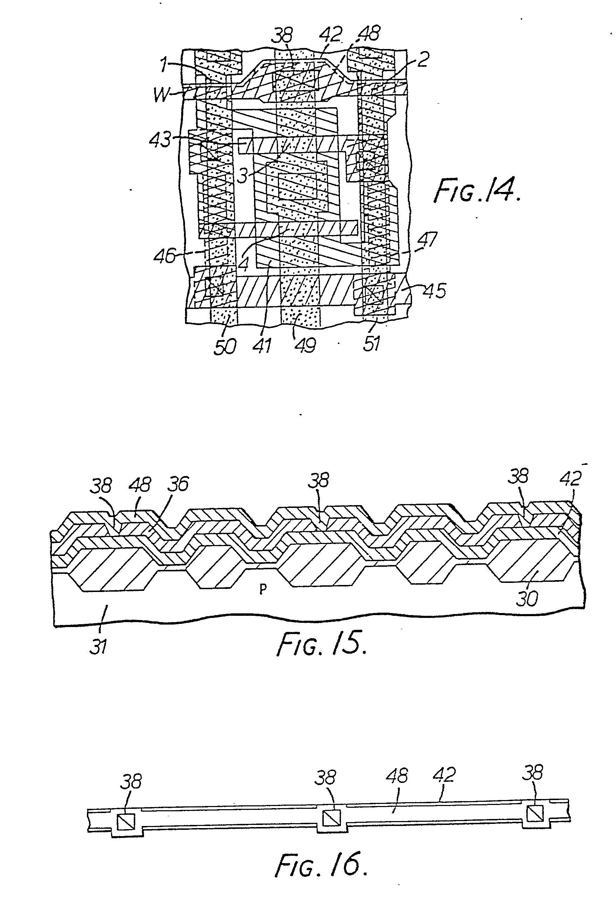

In the above described example, the resistors and the parallel wiring layers are formed of the same material, poly-Si. In the second example illustrated in Figures 10 to 16, they are formed of different materials, the resistors being constituted by poly-Si, while the parallel wiring layer is formed of $MoSi_2$.

The steps of making the semiconductor in the second example are as follows:—

1. A field insulation layer 30 is formed on P-type semiconductor substrate 31 by selective oxidation of the surface of the substrate (Figure 10). The field insulation layer 13 has a resistivity of about 20 to 50 ohm/cm and a thickness of about 1 μm.

2. Substrate 31 is heated to a high temperature to form a gate insulation layer 32 having a thickness of about 40—100 nm (400 to 1000 Å).

3. A contact hole 33 (Figure 11) is formed in the gate insulation layer 32 to the substrate 31, employing a photo-engraving process.

4. A first poly-Si conductive layer 34 is deposited (Figure 11) by chemical vapour deposition and an impurity, such as phosphorous ions, is defused into layer 34 in order to increase its conductivity.

5. First conductive layer 34 is selectively etched by photo-engraving as shown in Figure 11 in order to enable circuit elements to be formed in substrate 31.

6. An impurity, arsenic ions, is defused into the substrate 31 through the hole etched in layer 34, using the field insulation layer 30 and layer 34 as a mask; a $N^+$ region is thus formed in substrated 31. The $N^+$ region under the poly-Si layer 34 is deeper than that under the exposed area, as shown in Figure 11, because phosphorous ions included in the layer 34 defuse faster than the arsenic ions. The $N^+$ region is used as a drain and source region of each transistor.

7. The first conductive layer 34 is covered by a second insulation layer 36 (Figure 12) by chemical vapour deposition or thermal oxidation. Insulation layer 36 has a thickness of about 2000 to 4000 Å.

8. Contact holes, one of which is shown at 35 is formed by photo-engraving through insulating layer 36 to the first conductive layer 34.

9. A poly-Si layer 37 is deposited on insulation layer 36 and in the contact holes 35. Layer 37 is selectively etched as shown in Figure 12, except at the locations where the resistive elements are required.

10. A number of contact holes, one of which is shown at 38, are etched into the exposed insulation layer 36, down to the first conductive layer 34.

11. A $MoSi_2$ layer 39 is deposited by oxidation or sputtering and enters the holes 38, as shown in Figure 12.

12. The $MoSi_2$ layer is selectively etched, to reexpose all of the poly-Si layer 37, and to leave a layer connected in parallel with the first conductive layer 34 through the holes 38.

13. An insulating layer 40 (Figure 13) is applied to the surface and exterior aluminium electrodes are deposited on the surface and connected to the wiring layer 39 and the circuit elements thereunder through a plurality of contact holes; the aluminium electrodes are not shown in Figure 13. The aluminium electrodes are deposited by evaporation of aluminium at high temperature; but, because the $MoSi_2$ has a high melting point, layer 39 is not affected.

As will be appreciated, the circuit wiring, other than the aluminium electrodes, is formed by the poly-Si layer 34 and the $MoSi_2$ layer 39 connected in parallel. As the resistivity of $MoSi_2$ is about 2 to 5 ohms/cm and is about one tenth of the resistivity of poly-Si, the resistivity of the parallel connection is about one tenth of that of a single poly-Si layer. Accordingly, the delay time of the circuit connections is considerably reduced. Further the $MoSi_2$ adheres firmly to a $SiO_2$ or poly-Si layer and the rate of expansion is about equal to that of poly-Si; the reliability of the resulting semiconductor is thus improved.

Figure 14 is similar to Figure 7, but relates to the second example of semiconductor described in relation to Figures 10 to 13. In Figures 14, region 41 is the $N^+$ region and operates as the source and drain regions of the MOS transistors 1 to 4. Regions 42 to 45 are the first poly-Si layer 34 (Figure 11) and operate as the word line 7, the gate electrodes of the transistors 3 and 4, and the Vcc line, respectively. Regions 43 and 44 are connected to the drain regions of transistors 4 and 3, respectively, through the contact holes. Regions 46 and 47 are the second poly-Si layer and constitute resistors 5 and 6 of Figure 1. Region 48 is the $MoSi_2$ layer 39 connected to the word line 42 through contact holes. Lastly regions 49 to 51 are the aluminium layers and operate as the Vss line, the data line 8 and the data line 9, respectively.

As the second conductive poly-Si layers 46 and 47 are formed on the first conductive poly-Si layer, the area occupied is reduced and high integration can be achieved. While the $MoSi_2$ layer could be deposited over the second poly-Si layer, the process described above in which it replaces a part of the poly-Si layer is preferred to maintain differences in level in the external surface of the semiconductor as small as possible so that the aluminium layers are not harmed in use. It is of course possible to replace the $MoSi_2$ layer 39 by a layer of another metal silicide having high melting point, e.g. a tungsten silicide layer.

As in the semiconductor of Figures 2 to 9, the thickness of the insulation layer 36 between the first conductive layer 34 and each of the regions 37 and 39 of the second conductive layer is uniform, a feature which also helps to avoid undue variations in thickness in the completed semiconductor.

Figure 15 shows the parallel connection through contact holes 38, of the first poly-Si layer 42 and the $MoSi_2$ layer 48. Figure 16 shows a plan view of the word line and is similar to Figure 9, apart from the use of a metal silicide as the material of the second conductive layer.

**Claims**

1. A semiconductor device having a plurality of semiconductor elements having at least one PN junction, the device comprising: a substrate (10; 31); a first insulation layer (11, 12; 30, 32) on the substrate; a first conductive level (13; 34) on the first insulation layer; a second insulation layer (14; 36) on the first conductive level; a second conductive lever on the second insulation layer, the second conductive level having at least two separate regions of which a first region (17;·39) has a relatively high conductivity and a second region (18; 37) which has a relatively low conductivity and forms resistor means, characterised in that the first region (17; 39) of relatively high conductivity of the second conductive level is connected in parallel with the first conductive level (13; 34) through a plurality of contact holes (15; 38).

2. A semiconductor device according to claim 1, wherein the first and second conductive layers (13; 17, 18) are made of polycrystalline silicon.

3. A semiconductor device according to claim 1, wherein the first region (39) is made of metal silicide having high melting point and the second region (37) is made of polycrystalline silicon.

4. A semiconductor device according to any one of the preceding claims, in which the substrate is of one conductivity type, but contains a plurality of regions ($N^+$) having another conductivity type and operating as source and drain regions of MOS transistors, the second insulation layer (14; 36) having substantially uniform thickness.

5. A semiconductor device according to claim 4, wherein a low conductivity region (18; 37) is formed over a MOS transistor.

6. A memory device comprising a plurality of memory cells for storing information, each memory cell including a plurality of MOS transistors (1—4), and a resistor (18; 37) connected to an electrode of one of the MOS transistors, made of polycrystalline silicon and forming a first region (18, 37) of a second conductive level; a word line (7) connected to the memory cells for selecting a desired memory cell, the word line being constituted by two separated conductive layers (13, 17; 34, 39) connected in parallel and forming respectively a first conductive level (13, 34) and a second region (17, 39) of the second conductive level separated from the first region and having a higher conductivity than the first region; and a data line (8, 9) connected to each memory cell through a gate operated by a signal from the word line, the resistor (18; 37) and the second region being formed on an insulating layer (14; 36) having substantially uniform thickness.

7. A memory device according to claim 6, wherein the resistor (18) and the second region (17) of the second conductive level are made of polycrystalline silicon formed in the same step.

8. A memory device according to claim 6, wherein the resistor is formed over the MOS transistor.

9. A memory device according to claim 6, wherein one of the two conductive layers is made of metal silicide (39) having high melting point.

10. A method of manufacturing a semiconductor device, which method including the steps of forming a first insulation layer (11, 12; 20, 32) on a semiconductor substrate (10; 31); forming a first conductive level (13; 34) on the first insulating layer; forming a second insulating layer (14; 16) on the first conductive level; forming a second conductive level over the second insulating layer, the second conductive level includes a first region (17; 39) connected to the first conductive level (13; 34) in parallel and a second region (18; 37) constituting resistive means; and increasing the conductivity of the region connected to the first conductive level.

11. A method of manufacturing a semiconductor device according to claim 10, wherein the second region is formed over a circuit element formed in the substrate.

12. A method of manufacturing a semiconductor device according to claim 10, wherein the first region (17) is made of polycrystalline silicon.

13. A method of manufacturing a semiconductor device according to claim 10, wherein the first region (39) is made of metal silicide having a high melting point.

14. A method of manufacturing a semiconductor device according to claim 13, wherein the second region (18; 37) is made of polycrystalline silicon.

## Patentansprüche

1. Halbleiteranordnung aus mehreren Halbleiterbauelementen, die wenigstens eine pn-Übergang aufweisen, mit einem Substrat (10; 31), einer ersten Isolierschicht (11, 12; 30, 32) auf dem Substrat, einer ersten leitenden Schicht (13; 34) auf der ersten Isolierschicht, einer zweiten Isolierschicht (14; 36) auf der ersten leitenden Schicht, eine zweite leitende Schicht auf der zweiten Isolierschicht, wobei die zweite leitende Schicht wenigstens zwei getrennte Bereiche aufweist, von denen ein erster Bereich (17; 39) eine relativ hohe Leitfähigkeit aufweist und ein zweiter Bereich (18; 37), der eine relativ geringe Leitfähigkeit hat, einen Widerstand bildet, dadurch gekennzeichnet, daß der erste, eine relativ hohe Leitfähigkeit aufweisende Bereich (17; 39) der zweiten leitfähigen Schicht über mehrere Kontaktlöcher (15; 38) parallel zur ersten leitfähigen Schicht (13; 34) geschaltet ist.

2. Halbleiteranordnung nach Anspruch 1, dadurch gekennzeichnet, daß die erste und zweite leitfähige Schicht (13; 17, 18) aus polykristallinem Silikon bestehen.

3. Halbleiteranordnung nach Anspruch 1, dadurch gekennzeichnet, daß der erste Bereich (39) auf Metallsilicid, das einen hohen Schmelzpunkt aufweist, und der zweite Bereich (37) auf polykristallinem Silikon besteht.

4. Halbleiternanordnung nach einem der vorhergehenden Ansprüche, dadurch gekennzeichnet, daß das Substrat von einer ersten Leitfähigkeitsart ist, jedoch mehrere Bereiche (N⁺) aufweist, die von anderer Leitfähigkeitsart sind und als Source- und Drain-Bereiche von MOS-Transistoren arbeiten, und daß die zweite Isolierschicht (14; 36) eine im wesentlichen gleichmäßige Dicke aufweist.

5. Halbleiteranordnung nach Anspruch 4, dadurch gekennzeichnet, daß über einem MOS-Transistor ein Bereich (18; 37) geringer Leitfähigkeit gebildet ist.

6. Speicher mit mehreren zum Speichern von Informationen dienenden Speicherzellen, dadurch gekennzeichnet, daß die Speicherzellen jeweils mehrere MOS-Transistoren (1—4) und einen Widerstand (18; 37) aufweisen, der an eine Elektrode einer der MOS-Transistoren angeschlossen ist, aus polykristallinem Silikon besteht und einen ersten Bereich (18, 37) einer zweiten leitfähigen Schicht bildet, daß eine Wortleitung (7) an diieine Wortleitung (7) an die Speicherzellen zum Anwählen einer gewünschten Speicherzelle angeschlossen ist und durch zwei getrennte leitfähige Schichten (13, 17; 34, 39) gebildet wird, die parallel geschaltet sind und eine erste leitfähige Schicht (13; 34) und einen zweiten Bereich (17, 39) der zweiten leitfähigen Schicht bilden, wobei der zweite Bereich vom ersten Bereich getrennt ist und eine höhere Leitfähigkeit aufweist als der erste Bereich, daß eine Datenleitung (8, 9) mit jeder Speicherzelle über ein Gatter verbunden ist, das durch eine Signal auf der Wortleitung betätigt wird, und daß der Widerstand (18; 37) und der zweite Bereich auf einer Isolierschicht (14; 36) mit im wesentlichen gleichförmiger Dicke gebildet sind.

7. Speicher nach Anspruch 6, dadurch gekennzeichnet, daß der Widerstand (18) und der zweite Bereich (17) der zweiten leitfähigen Schicht aus in der gleichen Stufe gebildetem polykristallinem Silikon hergestellt sind.

8. Speicher nach Anspruch 6, dadurch gekennzeichnet, daß der Widerstand über dem MOS-Transistor gebildet ist.

9. Speicher nach Anspruch 6, dadurch gekennzeichnet, daß eine der zwei leitfähigen Schichten aus Metallsilicid (39) hergestellt ist, das einen hohen Schmelzpunkt aufweist.

10. Verfahren zur Herstellung einer Halbleiteranordnung, gekennzeichnet durch folgende Verfahrensschritte: Bildung einer ersten Isolierschicht (11, 12; 30, 32) auf einem Halbleitersubstrat (10; 31), Bildung einer ersten leitfähigen Schicht (13; 34) auf der ersten Isolierschicht, Bildung einer zweiten Isolierschicht (14; 16) auf der ersten leitfähigen Schicht; Bildung einer zweiten leitfähigen Schicht über der zweiten Isolierschicht, wobei die zweite leitfähige Schicht einen ersten Bereich (17; 39), der parallel zur ersten leitfähigen Schicht (13; 34) angeordnet ist, und einen zweiten Bereich (18; 37) aufweist, der einen Widerstand bildet, und Erhöhung der Leitfähigkeit des mit der ersten leitfähigen Schicht verbundenen Bereiches.

11. Verfahren zur Herstellung einer Halbleiteranordnung nach Anspruch 10, dadurch gekennzeichnet, daß der zweite Bereich über einen in dem Substrat ausgebildeten Kreiselement gebildet ist.

12. Verfahren zur Herstellung einer Halbleiteranordnung nach Anspruch 10, dadurch gekennzeichnet, daß der erste Bereich (17) aus polykristallinem Silikon besteht.

13. Verfahren zur Herstellung einer Halbleiteranordnung nach Anspruch 10, dadurch gekennzeichnet, daß der erste Bereich (39) aus Metallsilicid besteht, das einen hohen Schmelzpunkt aufweist.

14. Verfahren zur Herstellung einer Halbleiteranordnung nach Anspruch 13, dadurch gekennzeichnet, daß der zweite Bereich (18; 37) aus polykristallinem Silikon besteht.

## Revendications

1. Dispositif semi-conducteur comportant un certain nombre d'éléments semi-conducteurs ayant, au moins, une jonction PN, ce dispositif comprenant un substrat (10, 31) une première, couche isolante (11, 12, 30, 32) sur le substrat, un premier niveau conducteur (13, 34) sur la première couche isolante, une seconde couche isolante (14, 36) sur le premier niveau conducteur, un second niveau conducteur sur la seconde couche isolante, le second niveau conducteur ayant, au moins, deux régions séparées dont une première région (17, 39) a une conductivité relativement élevée, tandis que la seconde région (18, 37) a une conductivité relativement basse et forme des résistances, caractérisé en ce que la première région (17, 39) ayant une conductivité relativement élevée du second niveau conducteur est branchée en parallèle sur le premier niveau conducteur (13, 34) à travers un certain nombre de trous de contact (15, 38).

2. Dispositif semi-conducteur selon la revendication 1, charactérisé en ce que la première et la seconde couches conductrices (13, 17, 18) sont faites d'un silicium polycristallin.

3. Dispositif semi-conducteur selon la revendication 1, caractérisé en ce que la première région (39) est faite d'un siliciure mètallique ayant un point de fusion élevé tandis que la seconde région (37) est faite d'un silicium polycristallin.

4. Dispositif semi-conducteur selon l'une quelconque des revendications précédentes, caractérisé en ce que le substrat a une certain mode de conduction, mais contient plusieurs régions (N$^+$) ayant un autre mode de conduction et qui opèrent comme des régions de source et de drain des transistors MOS, la seconde couche isolante (14, 36) ayant une épaisseur pratiquement uniforme.

5. Dispositif semi-conducteur selon la revendication 4, caractérisé en ce qu'une région de faible conductivité (18, 37) est formée au-dessus d'un transistor MOS.

6. Dispositif de mémoire qui comprend un certain nombre de cellules pour conserver des informations chaque cellule incluant plusieurs transistors MOS (1—4) et une résistance (18, 37) connectée à une électrode de l'un des transistors MOS, fait d'un silicium polycristallin et formant une première région (18, 37) d'un second niveau conducteur, une ligne de mots d'information (7) connectée aux cellules de la mémoire, afin de sélectionner la cellule désirée de celle-ci, cette ligne étant constituée par deux couches conductrices séparées (13, 17, 34, 39) branchées en parallèle et formant respectivement un premier niveau conducteur (13, 34) et une seconde région (17, 39) du second niveau conducteur séparé dela première région et ayant une conductivité plus élevée que cette première région, et une ligne de données (8, 9) connectée à chaque cellule de mémoire à travers une porte commandée par un signal de la ligne de mots, la résistance (18, 37) et la seconde région étant formées sur une couche isolante (14, 36) ayant une épaisseur pratiquement uniforme.

7. Dispositif de mémoire selon la revendication 6, caractérisé en ce que la résistance (18) et la seconde région (17) du second niveau conducteur sont faites d'un silicium polycristallin formé pendant la même étape.

8. Dispositif de mémoire selon la revendication 6, caractérisé en ce que la résistance est formée au-dessus du transistor MOS.

9. Dispositif de mémoire selon la revendication 6, caractérisé en ce que l'une des deux couches conductrices est faite d'un siliciure métallique (39) ayant un point de fusion élevé.

10. Procédé pour fabriquer un dispositif semi-conducteur qui consiste à former une première couche isolante (11, 12, 30, 32) sur un substrat semi-conducteur (10, 31) à former un premier niveau conducteur (13, 34) sur la première couche isolante, à former une seconde couche isolante (14, 16) sur le premier niveau conducteur, à former un second niveau conducteur au-dessus de la seconde couche isolante, le second niveau conducteur comportant une première région (17, 39) branchée en parallèle sur le premier niveau conducteur (13, 34) et une seconde région (18, 37) constituant un élément ohmique, et à augmenter la conductivité de la région branchée en parallèle sur le premier niveau conducteur.

11. Procédé pour fabriquer un dispositif semi-conducteur selon la revendication 10, caractérisé en ce qu'on forme la seconde région au-dessus d'un élément de circuit formé dans le substrat.

12. Procédé pour fabriquer un dispositif semi-conducteur selon la revendication 10, caractérisé en ce que la première région (17) est faite d'un silicium polycristallin.

13. Procédé pour fabriquer un dispositif semi-conducteur selon la revendication 10, caractérisé en ce que la première région (39) est faite d'un siliciure métallique ayant un point de fusion élevé.

14. Procédé pour fabriquer un dispositif semi-conducteur selon la revendication 13, caractérisé en ce que la seconde région (18, 37) est faite de silicium polycristallin.

FIG. 1.

FIG. 2.

FIG. 3.

FIG. 4.

FIG. 5.

FIG. 6.

FIG. 7.

0 048 610

FIG. 8.

FIG. 9.

FIG. 10.

FIG. 11.

FIG. 12.

FIG. 13.

*Fig.14.*

*Fig. 15.*

*Fig. 16.*